# EUROPEAN PATENT APPLICATION

(11) **EP 4 422 356 A1**
(43) Date of publication of application: **28.08.2024**
(21) Application number: 22883312.5
(22) Date of filing: 29.09.2022
(51) Int. Cl.: H05K 1/02, H05K 3/20, H01M 10/48, H01M 50/213, H01M 50/224, H01M 50/262, H01M 50/264, H01M 50/271, H01M 50/284, H01M 50/287, H01M 50/291, H01M 50/507, H01M 50/519, H01M 50/569

(54) **WIRING BOARD, MANUFACTURING METHOD THEREOF, AND BATTERY PACK PROVIDED WITH WIRING BOARD**

(30) Priority: 21.10.2021 JP 2021172413
(71) Applicant: Panasonic Energy Co., Ltd., Osaka 570-8511 (JP)
(72) Inventor: MATSUSHITA, Fumiya, Kadoma-shi, Osaka 571-0057 (JP); MATSUBARA, Shota, Kadoma-shi, Osaka 571-0057 (JP)
(74) Representative: Novagraaf International SA
(86) International application number: PCT/JP2022/036349
(87) International publication number: WO 2023/068004

(57) **Abstract**

A wiring board includes a patterned metal plate made of a metal plate cut in a wiring pattern including lead lines including a connection portion and an insulating layer disposed on a surface of the patterned metal plate. The insulating layer has an exposure opening exposing the connection portion. A method of manufacturing a wiring board includes: a cutting step of providing a patterned metal plate by cutting a metal plate in a wiring pattern, the patterned metal plate including a coupling portion and lead lines including a connection portion, adjacent lead lines being coupled to each other with the coupling portion; a laminating step of providing an intermediate board including the patterned metal plate and an insulating layer on a surface of the patterned metal plate by bonding an insulating material on the surface of the patterned metal plate; and a modifying step of separating the plurality of lead lines from each other by locally removing a portion of the intermediate board in a removal region including the coupling portion.

## Description

### TECHNICAL FIELD

The present invention relates to a wiring board usable in various applications, a method of manufacturing the wiring board, and a battery pack including the wiring board.

### BACKGROUND ART

A printed-wiring board is used instead of wiring a lot of lead wires (PTL 1 and PTL 2). The printed-wiring board includes a wiring pattern formed by bonding a copper foil on a surface of an insulating substrate. The copper foil of the printed-wiring board is so thin, with a thickness ranging approximately from 20 to 70 µm, that a current flowing through it may be limited. A printed-wiring board that flows a high current through a thin copper foil requires a wide pattern width. For example, a printed-wiring board having a copper foil with a thickness of 35 µm requires a pattern width of 1 mm for a flowing current of about 1 A. For this reason, a printed-wiring board requires a pattern width ranging from 20 to 50 mm for flowing a current ranging from 20 to 50 A, and a very wide pattern width of 100 mm for flowing a current of 100 A. Such a printed-wiring board is hardly used in most applications that require space efficiency.

### CITATION LIST

### Patent Literature

PTL 1: Japanese Patent Laid-Open Publication No. 2011-134540
PTL 2: Japanese Patent Laid-Open Publication No. 2011-216366

### SUMMARY OF THE INVENTION

Since a printed-wiring board allows currents to flow through a thin copper foil, a wiring pattern that flows high currents requires a large pattern width, accordingly increasing its size. It also has a disadvantage of taking time and effort in manufacturing, resulting in high manufacturing costs. This is because the printed-wiring board is manufactured as follows: A copper foil with a predetermined thickness is stacked, by copper plating, on the entire surface of a glass epoxy substrate, then a mask for forming a wiring pattern is applied on the surface of the copper foil, and then, the copper foil is etched to remove excess areas of the copper foil, thereby completing the wiring pattern.

The present disclosure has been developed for an object of solving the above-mentioned problems, and an object of the present disclosure is to provide a wiring board that has excellent high-current characteristics and mass-produced inexpensively, a method for manufacturing the wiring board, and a battery pack provided with the wiring board.

A wiring board according to an aspect of the present disclosure includes: a patterned metal plate made of a metal plate cut in a wiring pattern, the patterned metal plate including lead lines including a connection portion; and an insulating layer disposed on a surface of the patterned metal plate. The insulating layer has an exposure opening therein allowing the connection portion to be exposed through the exposure opening.

Since the wiring board described above is produced by cutting a metal plate into a wiring pattern having lead lines, such a wiring pattern of the wiring board is produced more efficiently in a short time than the wiring patterns of conventional printed-circuit boards produced by etching. Moreover, the wiring board has advantages that, since the wiring board is produced by cutting the metal plate in the wiring pattern, the current-carrying capacity of lead lines is large and the wiring board is efficiently mass-produced while implementing the wiring pattern having a high current-carrying capacity. Further, the wiring board has an additional advantage that, even with a large thickness of the metal plate adapted for an increased current-carrying capacity of the wiring pattern, the wiring board is mass-produced efficiently and inexpensively.

In a wiring board according to another aspect of the present disclosure, the patterned metal plate may be made of the metal plate punched or cot in the wiring pattern.

The wiring board has an advantage of being mass produced more efficiently and inexpensively since the wiring board is made from a metal plate into a patterned metal plate by punching or other cutting processes such as wire cutting and laser cutting.

In a wiring board according to another aspect of the present disclosure, the patterned metal plate may be made of the metal plate having a thickness of 0.1 mm or more.

In a wiring board according to another aspect of the present disclosure, the wiring board may have a separation hole therein passing through both the patterned metal plate and the insulating layer. The separation hole is provided between adjacent lead lines out of the plurality of lead lines. The separation hole separates the adjacent lead lines from each other.

Since the abnormal wiring board may be produced by bonding the insulating layer on the patterned metal plate configured by coupling various lead lines, an then, the separation hole may be formed to separate adjacent lead lines, the insulating layer is bonded on the patterned metal plate while the lead lines are arranged in place, resulting in efficient mass production. The wiring board may be manufactured as follows: The patterned metal plate is produced by cutting the metal plate in the wiring pattern in which the lead lines are not separated but coupled to each other with coupling portions, then bonding the insulating layer on the patterned metal plate followed by cutting both the insulating layer and the patterned metal plate to remove the coupling portions, thereby separating the lead lines from one another. Therefore, the insulating layer may be bonded such that the lead lines are arranged in place without misalignment when the insulating layer is laminated. For this reason, there is no need for the process in which a plurality of lead lines not coupled to each other must be disposed in place in the wiring pattern, and in which the surface of each of the plurality of lead lines not coupled to each other must be bonded with an insulating layer. In the method in which the insulating layer is bonded on the surface of the lead lines coupled to one another, disposing all the lead lines at respective fixed positions takes time and, in addition, the read lines tend to suffer misalignment in the process in which the insulating layer is bonded on the lead lines arranged at their fixed positions. For this reason, it is difficult to mass produce such wiring plates having an accurate wiring pattern with a high yield and a high efficiency. In contrast, however, the wiring plates described above have a feature that the wiring plates may be produced in an accurate wiring pattern while preventing the lead lines from suffering misalignment. In addition, even for a complicated wiring pattern, the wiring plates can also be mass produced highly efficiently and inexpensively.

In a wiring board according to another aspect of the present disclosure, the connection portion may include a projection protruding through the exposure opening.

In a wiring board according to another aspect of the present disclosure, the projection may a surface either being flush with a surface of the insulating layer or protruding from the insulating layer.

A method of manufacturing a wiring board according to an aspect of the present disclosure includes: a cutting step of providing a patterned metal plate by cutting a metal plate in a wiring pattern, the patterned metal plate including a coupling portion and a plurality of lead lines including a connection portion, adjacent lead lines of the plurality of lead lines being coupled to each other with the coupling portion; a laminating step of providing an intermediate board including the patterned metal plate and an insulating layer on a surface of the patterned metal plate by bonding an insulating material on the surface of the patterned metal plate; and a modifying step of separating the plurality of lead lines from each other by locally removing a portion of the intermediate board in a removal region including the coupling portion.

In the method of manufacturing described above, the patterned metal plate is produced by cutting the metal plate in the wiring pattern in which the lead lines is coupled to one another with the coupling portions without separating the lead lines from one another (the step of cutting), the insulating layer is placed on the patterned metal plate by bonding the insulating material on the patterned metal plate to produce an intermediate board (the step of laminating), and then, the lead lines are separated from one another by removing both the insulating layer and the patterned metal plate in removal regions including the coupling portions (the step of modifying), thereby manufacturing the wiring board. Therefore, the insulating layer may be bonded in the step of laminating with the lead lines arranged at fixed positions without suffering misalignment. For this reason, the lead lines not coupled to one another may be disposed at the fixed positions in the wiring pattern.

This method requires no need for the process of disposing the lead lines not coupled to one another at the fixe positions and then bonding the insulating layer on the surfaces of the lead lines. In a method of bonding an insulating layer on the surfaces of lead lines not coupled to one another, the lead lines tend to suffer misalignment; therefore, an insulating layer is hardly bonded on the lead lines while being arranged at fixed positions. This is because that, even if the lead lines are once arranged at the fixed positions, the lead lines are prone to out of position at the timing for bonding the insulating layer on the surface of each lead line. For this reason, it is difficult to mass-produce such precise wiring boards efficiently with a high yield. In contrast, the manufacturing method described above has advantages that precise wiring patterns are produced while preventing the lead lines from suffering out of position and that, even for more complicated wiring patterns, the patterns may be mass produced efficiently at low cost.

In a method of manufacturing a wiring board according to another aspect of the present disclosure, in the laminating step, the insulating material may be bonded on the surface of the patterned metal plate, the insulating material having an exposure opening allowing the connection portion to be exposed through the exposure opening.

The manufacturing method described above allows the efficient mass-production of the wiring boards in which the connection portions are exposed. The connection portions exposed have advantages that, with a device integrating the wiring board thereinto, the connection portions are efficiently connected to the connection terminals of the device by welding, soldering, or any other method.

In a method of manufacturing a wiring board according to another aspect of the present disclosure, the connection portion may be embossed to cause the connection portion to protrude through the exposure opening.

The wiring board produced by the manufacturing method described above has advantages that the connection portions may be reliably and stably welded. This is because the connection portions protruding from the exposure openings may be welded while being in close contact with or in the vicinities of welding surfaces.

In a method of manufacturing a wiring board according to another aspect of the present disclosure, the lead lines may include connection portions including the connection portion, the connection portions are flush with one another.

The wiring board has advantages that the connection terminals of an electronic appliance can be arranged in the same plane and then connected simply and efficiently to the connection portions of the wiring board connected to the appliance.

A battery pack including a wiring board according to an aspect of the present disclosure includes: a battery block including a plurality of battery cells and a plurality of connection terminals, the battery block having a terminal surface on which the plurality of connection terminals are provided; a wiring board including a plurality of connection portions connected to the plurality of connection terminals of the battery block, respectively; and a case accommodating an assembled battery therein, the assembled battery including the battery block and the wiring board coupled to the battery block. The wiring board includes: a patterned metal plate made of a metal plate cut in a wiring pattern, the patterned metal plate including a plurality of lead lines coupled to the plurality of connection portions; and an insulating layer bonded onto a surface of the patterned metal plate such that adjacent lead lines out of the plurality of lead lines are disposed at fixed positions and insulated from each other.

Since the battery pack described above includes the wiring board, as its internal wiring, which has excellent high current characteristics and also permits inexpensive mass-production, the battery pack can feature the advantage of being mass-produced while reducing its manufacturing cost through use of the wiring board applicable to wiring for passing even high currents. This is because the battery pack describe above adopts the wiring that includes the wiring board having the lead lines made of the metal plate, instead of internal wiring by using a conventional printed-circuit board, lead wires, or the like. In particular, the battery pack describe above has the advantages of simplification of the wiring process that would otherwise be complicated due to the use of lead wires, and simplification of the wiring process by adopting a high-current wiring as well in the wiring board. The high-current wiring is difficult to realize by using a printed-circuit board.

In a battery pack including a wiring board according to another aspect of the present disclosure, the wiring pattern of the wiring board may include: a power line connected to a load current line of the battery block; and a detection line configured to detect conditions of the plurality of battery cells.

In the battery pack described above, the wiring board can be used to wire both the power line for flowing load currents and the detection line for detecting battery conditions including the voltages and temperatures of the battery cells. Therefore, it allows an increase in efficiency of its internal wiring processes, leading to a reduced assembling cost and mass production of the battery pack.

In a battery pack including a wiring board according to another aspect of the present disclosure, the assembled battery may further include a printed-wiring board connected to the wiring board.

In a battery pack including a wiring board according to another aspect of the present disclosure, the printed-wiring board may include a current-detecting circuit for the plurality of battery cells.

In a battery pack including a wiring board according to another aspect of the present disclosure, the printed-wiring board may be connected to the wiring board with a flexible board (FPC).

The battery pack described above has advantages that the wiring board and the printed-wiring board can be connected with the FPC, with the wiring board and the printed-wiring board being disposed at an optimal position.

In a battery pack including a wiring board according to another aspect of the present disclosure, the battery block may have a block shape having an overall length, a lateral width, and a vertical width, the overall length being larger than the lateral width and the vertical width, and the printed-wiring board may be disposed on an end surface of the battery block.

The battery pack described above has advantages that the printed-wiring board and the wiring board can be connected to each other with the FPC, with the printed-wiring board being disposed at an optimal position excellent in space efficiency.

In a battery pack including a wiring board according to another aspect of the present disclosure, the connection terminals may be flush with one another and provided on the terminal surface, the terminal surface being one of outer circumferential surfaces of the battery block. The connection portions of the wiring board may be flush with one another and disposed on the terminal surface.

The battery pack described above has advantages that the wiring board can be disposed on the terminal surface of the battery block and each of the connection portions can be connected highly efficiently to a corresponding one of the connection terminals.

In a battery pack including a wiring board according to another aspect of the present disclosure, the connection portions of the wiring board may be welded to the connection terminals of the battery block.

In a battery pack including a wiring board according to another aspect of the present disclosure, the insulating layer may have exposure openings therein through which the plurality of connection portions are exposed. The connection portions of the wiring board may include projections positioned in the exposure openings, the projections being welded to the connection terminals by laser welding.

The battery pack described above has advantages that the projections can be welded to the connection terminals reliably and stably. This is because, since the projections protruding through the exposure openings are disposed on the connection portions, the projections can be welded by laser in the state of being in close contact with or in the vicinities of the connection terminals. Since laser welding is done by melting metal, the clearance between metals to be welded to each other is a possible factor in impeding reliable welding. The battery pack described above can achieve reliable welding because the projections can be welded by laser in the state of being in close contact with or in the vicinities of the connection terminals.

In a battery pack including a wiring board according to another aspect of the present disclosure, the case may include: a case tube having both ends opened, and case lids closing the both ends of the case tube. The printed-wiring board may be disposed on an inner side of the case lids. The assembled battery may be disposed inside the case tube such that the wiring board is disposed on an outer circumferential surface of the battery block.

In a battery pack including a wiring board according to another aspect of the present disclosure, the battery block may include battery units linearly disposed and a coupling bolt linearly coupling the battery units to one another. Each of the battery units may include a battery holder disposing the battery cells at fixed positions. The coupling bolt may pass through the battery holder such that end portions of the coupling bolt are coupled to the case lids to linearly couple the plurality of battery units to one another.

In a battery pack including a wiring board according to another aspect of the present disclosure, each of the battery units further may include a board holder dispose the printed-wiring board in a fixed position. The coupling bolt may pass through both the board holder and the battery holder, the end portion of the coupling bolt being coupled to one of the case lids. The battery blocks, the printed-wiring board, and one of the case lids are coupled unitarily with the coupling bolt.

The battery pack described above has advantages that the battery blocks can be inserted into the case tube in the state of the printed-wiring board, the battery blocks, and one of the case lids being coupled in an integral structure, followed by efficiently assembling them.

In a battery pack including a wiring board according to another aspect of the present disclosure, the case tube may be a metal tube having an identical cross-sectional shape. The case lids and the case tube may be coupled to one another with a set screw through the case lids into one of the case tube.

In a battery pack including a wiring board according to another aspect of the present disclosure, the battery block may include one or more positioning projections disposing the wiring board at a fixed position. The wiring board may have one or more positioning holes therein guiding the one or more positioning projections, respectively. The wiring board may be disposed at the fixed position of the battery block by guiding the one or more positioning projections into the one or more positioning holes.

In a battery pack including a wiring board according to another aspect of the present disclosure, the one or more positioning holes may include positioning holes adjacent to the connection portions.

In a battery pack including a wiring board according to another aspect of the present disclosure, the one or more positioning holes may include: a slit-shaped positioning hole positioned between adjacent lead lines; and a dot-shaped positioning hole disposed adjacent to the plurality of connection portions. The one or more positioning projections may include: a positioning projection guided into the slit-shaped positioning hole; and a positioning projection guided into the dot-shaped positioning hole.

### BRIEF DESCRIPTION OF DRAWINGS

FIG. 1 is a partially enlarged perspective view of a wiring board according to an exemplary embodiment of the present disclosure.
FIG. 2 is a plan view of the wiring board illustrated in FIG. 1.
FIG. 3 is an enlarged cross-sectional view of a main part of a connection structure between a connection portion of the wiring board illustrated in FIG. 1 and a connection terminal.
FIG. 4 is a plan view illustrating one example of a patterned metal plate produced by cutting a metal plate in a wiring pattern in which lead lines are coupled to one another with coupling portions.
FIG. 5 is a plan view illustrating one example of an intermediate board in which an insulating layer is formed on the surface of the patterned metal plate illustrated in FIG. 4.
FIG. 6 is a perspective view of a battery pack according to the embodiment of the present disclosure.
FIG. 7 is a cross-sectional view of the battery pack taken along line VII-VII shown in FIG. 6.
FIG. 8 is a cross-sectional view of the battery pack taken along line VIII-VIII shown in FIG. 6.
FIG. 9 is a cross-sectional view of the battery pack taken along line IX-IX shown in FIG. 6.
FIG. 10 is an exploded perspective view of the battery pack illustrated in FIG. 6.
FIG. 11 is an exploded perspective view of the battery pack illustrated in FIG. 10.
FIG. 12 is a plan view of an assembled battery illustrated in FIG. 11. FIG. 3 corresponds to a cross-sectional plane of the assembled battery taken along line III-III shown in FIG. 12.
FIG. 13 is an exploded perspective view of the assembled battery illustrated in FIG. 12.
FIG. 14 is an exploded perspective view of a battery unit illustrated in FIG. 13.

### DESCRIPTION OF EMBODIMENTS

The present disclosure will be detailed below with reference to the accompanying drawings. In the following description, terms (for example, "top," "bottom," and other terms including those terms) indicating specific directions or positions are used as necessary. However, these terms are used for facilitating the understanding of the present disclosure referring to the drawings, and the technical scope of the present invention is not limited by the meanings of these terms. Moreover, portions having the same reference numerals and symbols, which appear in a plurality of the drawings, indicate the same or equivalent portions or members.

The following exemplary embodiments illustrate specific examples of the technical idea of the present disclosure, and is not intended to limit the present invention to the following exemplary embodiments. Unless otherwise specified, dimensions, materials, shapes, relative arrangements, and the like of constituent components to be described below are not intended to limit the scope of the present invention, but are intended to be illustrative. Contents described in one exemplary embodiment and example are also applicable to other exemplary embodiments and examples. Sizes, positional relationships, and the like of members illustrated in the drawings may be exaggerated in order to clarify the description.

### Exemplary Embodiment 1

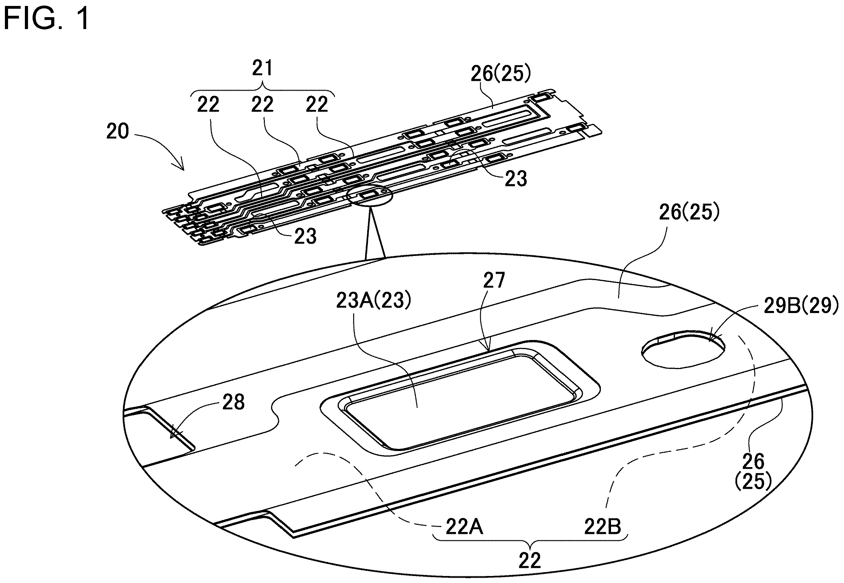

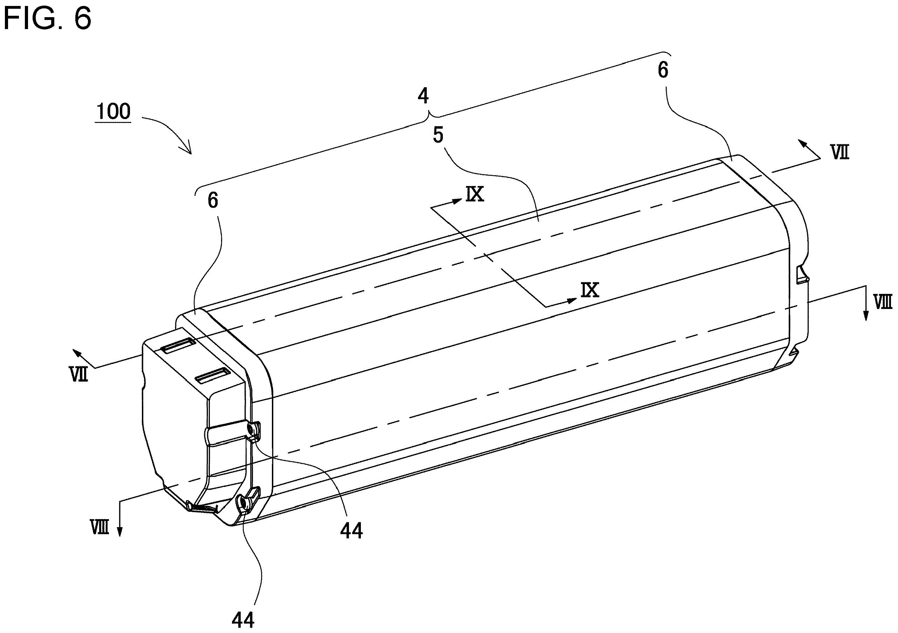

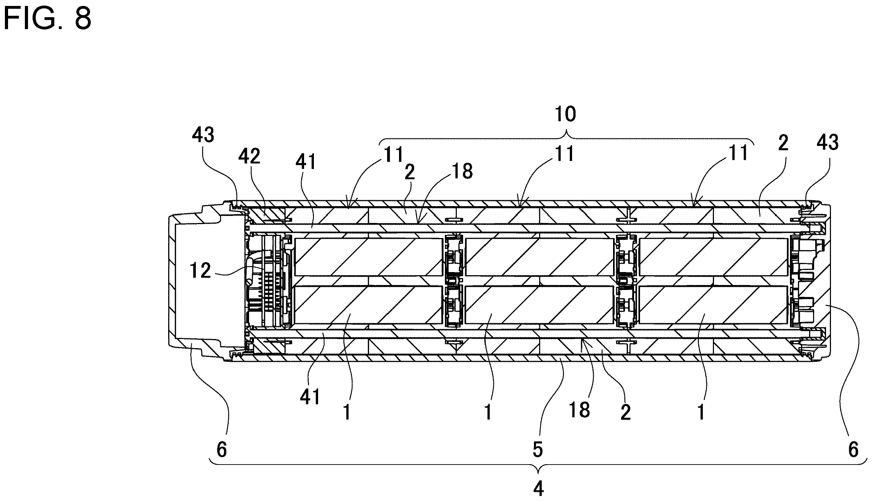

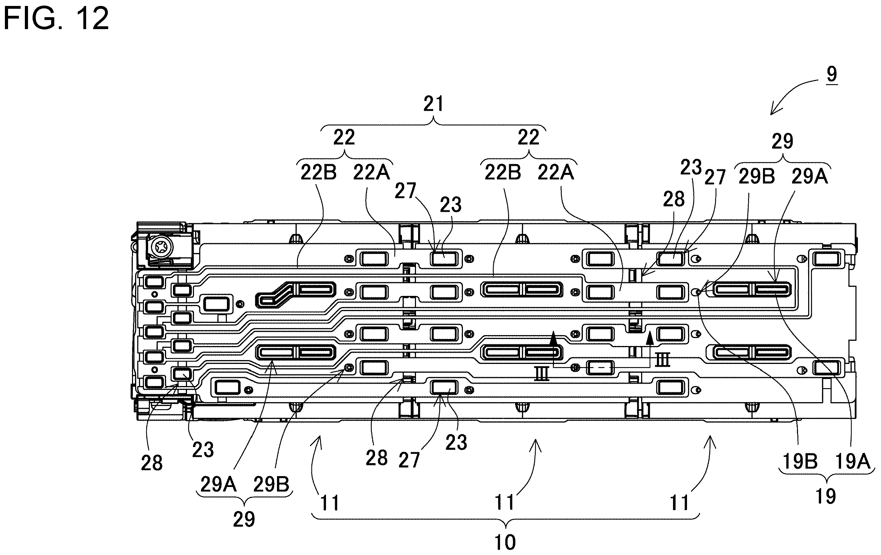

FIGS. 1 to 5 illustrate wiring board 20 to be detailed later that is built in a battery pack illustrated in FIGS. 6 to 13. However, the present disclosure does not specify the structure and wiring pattern of the wiring board as described below, so that the wiring board may have a structure optimal for various applications.

### Wiring Board 20

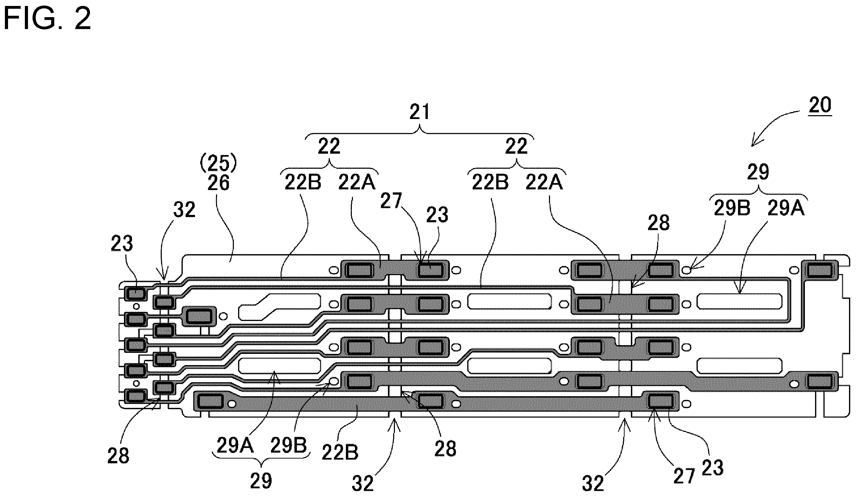

In wiring board 20 illustrated in FIGS. 1 and 2, insulating layer 25 is bonded on a surface of patterned metal plate 21 that has been produced by cutting a metal plate in a wiring pattern in which lead lines 22 including connection portions 23 is disposed. Insulating layer 25 has exposure openings 27 therein through which connection portions 23 are exposed. Connection portions 23 are exposed through exposure openings 27 and connected to connection terminals of an electronic device by welding or any other method.

### Patterned Metal Plate 21

Patterned metal plate 21 is produced by punching a conductive metal plate, such as a copper plate, a nickel plate, or an aluminum plate. The thickness of patterned metal plate 21 is, for example, 0.1 mm or more. This thickness allows the punching of the metal plate in a wiring pattern coupling the lead lines 22 to one another, followed by bonding insulating layer 25 on the thus-punched metal plate as it is held in a plate state, and also allows the current-carrying capacities of lead lines 22 to be made larger than that of the copper foil of a printed board. Patterned metal plate 21 may be thick to increase the current-carrying capacities.

The patterned metal plate is produced by punching in the case described above; however, in a small lot production or the like, the patterned metal plate may be produced more inexpensively by cutting processing such as wire cutting, laser cutting or the like.

Patterned metal plate 21 may provide an approximately six-time large current-carrying capacity. This can be achieved, for example, by 0.2 mm-thickness copper plate, even with a pattern width the same as that of a conventional printed-wiring board using a 35 µm-thickness copper foil. For example, for each of lead lines 22 having a current-carrying capacity of 25A, a 0.2 mm-thickness metal plate reduces its pattern width to 1/5 of the pattern width of a printed-circuit board. Moreover, patterned metal plate 21 with a 2 mm-thickness metal plate allows a current of 200 A to flow, allowing a fifty-time flowing current to flow through it than the printed-wiring board with a 35 µm-thickness copper foil. Therefore, patterned metal plate 21 may be made of a metal plate with an optimum thickness in consideration of flowing currents in applications thereof. Patterned metal plates 21 is efficiently mass-produced by punching even with a thick metal plate. Further, the thick metal plate has advantages that, after having been punched in a predetermined wiring pattern, it can be held in a planar state, resulting in efficiently bonding of insulating layer 25 thereon.

Patterned metal plate 21 is produced by punching a metal plate in a wiring pattern including lead lines 22; however, after being punched, adjacent lead lines 22 are coupled to each other with a connection portion 24. Coupling portions 24 couple adjacent lead lines 22 to each other at portions where lead lines 22 are disposed at their fixed positions. In patterned metal plate 21 illustrated in the plan view of FIG. 2, adjacent lead lines 22 are coupled to each other at two to three locations. Insulating material 26 is bonded on the surface of patterned metal plate 21 in which lead lines 22 are coupled to each other with coupling portions 24, thereby producing intermediate board 30. In intermediate board 30, adjacent lead lines 22 are coupled to each other with coupling portions 24. In order to separate lead lines 22 from each other, coupling portions 24 are removed by locally punching intermediate board 30 in removal regions 31 including coupling portions 24. In patterned metal plate 21 from which the coupling portions 24 have been removed, lead lines 22 are separated from each other. In the processing of partially removing intermediate board 30, only coupling portions 24 are removed together with corresponding portions of insulating layer 25. Therefore, the metal plate constituting the wiring pattern having not been removed remains coupled to insulating layer 25 forms one wiring board 20.

Insulating material 26 is bonded on the surface of patterned metal plate 21, so that patterned metal plate 21 is located on the inner side with respect to the surface of insulating layer 25 formed on the surface of patterned metal plate 21. In patterned metal plate 21, connection portions 23 may protrude through exposure openings 27 of insulating layer 25 such that the surfaces of connection portions 23 are flush with the surface of insulating layer 25 or, alternatively, protrude from the surface of insulating layer 25. In wiring board 20 including connection portions 23 with the surfaces protruding through exposure openings 27 flush with the surface of insulating layer 25 or, alternatively, with the surfaces protruding from the surface of insulating layer 25, connection portions 23 may be connected stably and reliably to connection terminals 13 of an electric device. This is because the connection portions may be connected while the surfaces of projections 23A disposed on connection portions 23 contact or are located in the close vicinities to the surfaces of connection terminals 13. In particular, connection portions 23 to be laser-welded to connection terminals 13 of an electronic device can be reliably welded by laser beam irradiated while the surfaces of projections 23A closely contact the surfaces of connection terminals 13.

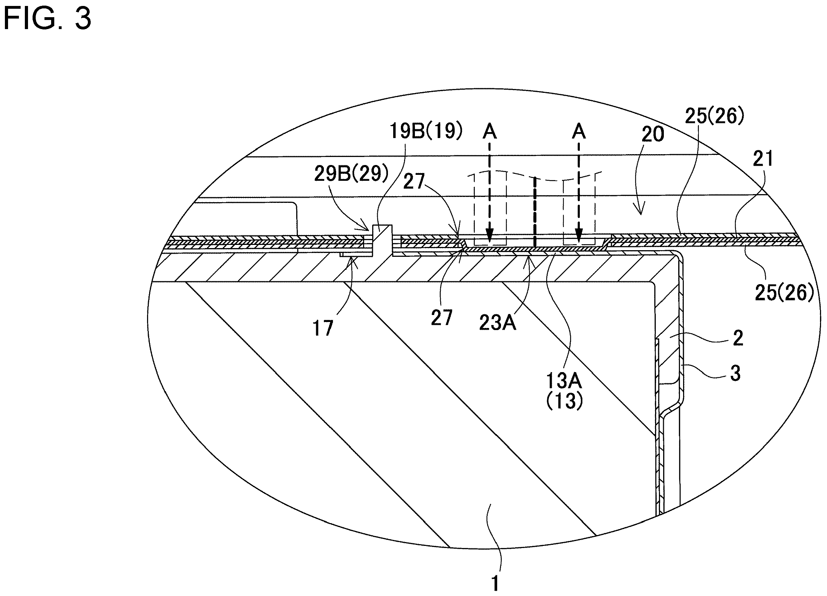

The laser welding is carried out such that, as illustrated in the enlarged cross-sectional view of FIG. 3, connection portion 23 of patterned metal plate 21 is pressed in the direction indicated by arrows A and is irradiated with a laser beam. A connection portion without a projection may prevent the insulating layer bonded on the surface of the patterned metal plate from closely contacting connection terminal 13 (13A), thereby preventing reliable laser welding. Connection portion 23 with projection 23A allows the connection portion to protrude through exposure opening 27, and allows its surface to closely contact connection terminal 13 (13A), resulting in the reliable welding. Other than by laser welding, also even by spot welding of connection portion 23 to connection terminal 13 (13A), it is not expected to have stable contact between connection portion 23 and connection terminal 13 (13A) due to insulating layer 25. Further, also even by soldering of connection portion 23 to connection terminal 13 (13A), a wide clearance between connection portion 23 and connection terminal 13 inhibits the solder melted between connection portion 23 and connection terminal 13 from filling the clearance without voids, resulting in unstable connection. In order to prevent this problem, strongly pressing of connection portions 23 may be expected to elastically deform patterned metal plate 21 such that connection portions 23 closely contact connection terminals 13; however, thick patterned metal plate 21 is hardly elastically deform, resulting in unstable and unreliable contact of connection portions 23 with connection terminals 13, which inhibits reliable connection. Further, thick insulating layer 25 of a wiring board for achieving higher withstand voltage may cause insulating layer 25 to prevent connection portions 23 from closely contacting connection terminals 13, preventing reliable connection.

Connection portion 23 including projection 23A closely contact the surface of connection terminal 13 without elastically deforming patterned metal plate 21 and without crushing insulating layer 25 into a thin layer, which allows reliable welding of them by laser welding, spot welding, or any other method. Further, such close contact of connection portion 23 with the surface of the connection terminal also allows reliable welding of them by soldering.

In addition, patterned metal plate 21 with connection portions 23 including projections 23A has also another advantage that projections 23A are guided to exposure openings 27 of insulating layer 25 for avoiding their misalignment, followed by bonding insulating layer 25 on patterned metal plate 21. In wiring board 20, instead of bonding insulating layer 25 on patterned metal plate 21 including projections 23A, insulating layer 25 may be bonded on patterned metal plate 21 and projections 23A may be formed in connection portions 23. Patterned metal plate 21 may include projections 23A by embossing them in connection portions 23 while either insulating layer 25 is not bonded on the patterned metal plate or insulating layer 25 is bonded on it. Wiring board 20 illustrated in FIGS. 1 and 3 includes projections 23A each of which has an external shape along the inner side surface of exposure opening 27. The clearance between exposure opening 27 and projection 23A preferably ranges from 0.1 to 1 mm, which allows projection 23A to be disposed in exposure opening 27. Further, in wiring board 20 illustrated in FIG. 1, rectangular projections 23A are disposed in rectangular exposure openings 27; however, exposure openings 27 may be polygonal, circular, or elliptical, with projections 23A being disposed inside of them.

### Insulating Layer 25, Insulating Material 26

Insulating layer 25 is formed by bonding insulating material 26 on patterned metal plate 21 with insulating material 26 having exposure openings 27 through which connection portions 23 to be exposed. Insulating material 26 is bonded on patterned metal plate 21 with a bonding agent or an adhesion layer. Insulating material 26 may have exposure openings 27 therein formed as follows: Insulating material 26 which does not have exposure openings 27 is bonded on patterned metal plate 21. Then, insulating layer 25 is removed, by punching, from the surfaces of connection portions 23 to form exposure openings 27. In this method, insulating material 26 is bonded while any bonding material is not applied to surfaces of the insulating material 26 facing connection portions 23. Then, insulating layer 25 on the facing surfaces of connection portions 23 is removed by punching to form exposure openings 27.

Insulating material 26 may be made of a plastic insulating sheet. Examples of plastic of the insulating sheet may include polyethylene, polystyrene, and vinyl chloride. Insulating material 26 may have a thickness optimal for intended applications in consideration of withstand voltage and the like. For example, for the wiring board of a battery pack, an insulating sheet with a thickness of several tens of micrometers may be used. Since wiring board 20 has a high withstand voltage by increasing the thickness of insulating material 26, insulating material 26 is made of an insulating sheet having a thickness optimal for the intended applications. An insulating sheet with a thickness of several hundred micrometers or more allows wiring board 20 to have a withstand voltage higher than several hundred volts.

Insulating material 26 may be made of a plastic insulating sheet having translucency. Translucent insulating material 26 allows the surface of patterned metal plate 21, e.g., the wiring pattern to be visually inspect from outside even in the case where insulating materials 26 are bonded on the both sides of patterned metal plate 21. This configuration has a feature that the each of lead lines 22 can be connected while its connection position is visually checked. Wiring board 20 illustrated in FIGS. 1, 2, and 4 includes insulating materials 26 placed on both surfaces of patterned metal plate 21, and patterned metal plate 21 can be seen through insulating layer 25 on the upper surface. However, insulating material 26 is not necessarily an insulating sheet having translucency, and may be a non-light-shielding insulating sheet. Alternatively, a translucent insulating sheet may be placed only on one surface and a non-translucent insulating sheet may be placed on the other surface.

### Method of Manufacturing Wiring Board 20

Wiring board 20 is manufacturing by a cutting step of punching a metal plate into patterned metal plate 21, a laminating step of bonding insulating material 26 on a surface of patterned metal plate 21 to produce intermediate board 30 including insulating layer 25 on the surface of patterned metal plate 21, and a modifying step of providing intermediate board 30 by forming separation holes 28 passing through intermediate board 30.

### Cutting Step

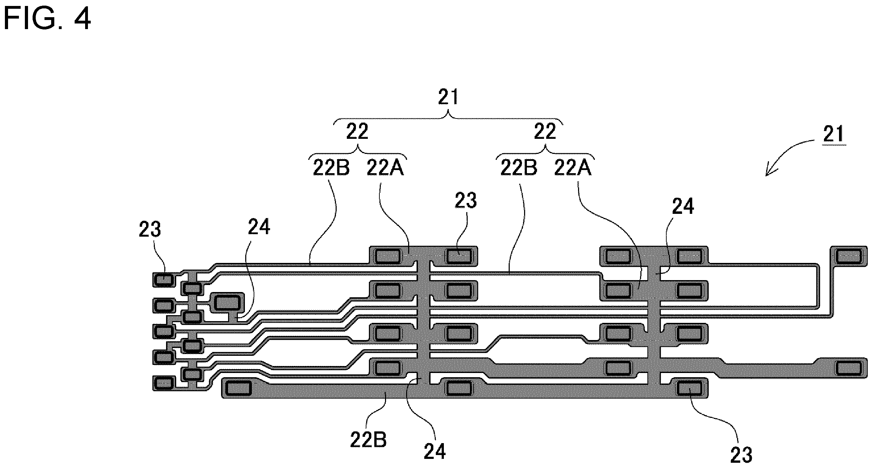

In this step is, as illustrated in FIG. 4, a metal plate is cut in a wiring pattern including lead lines 22 coupled to one another with coupling portions 24, thereby producing patterned metal plate 21. Patterned metal plate 21 is produced, by cutting, as one-piece patterned metal plate 21 in which adjacent lead lines 22 are coupled to each other with coupling portions 24 such that all of lead lines 22 are coupled to one another. Patterned metal plates 21 may be efficiently mass-produced by punching metal plates. A laser beam may also be used to cut the metal plates to produce patterned metal plates 21; likewise, this step may adopt any other method capable of cutting the metal plates in a wiring pattern. In patterned metal plate 21, each lead line 22 has a pattern width optimal for a flowing current passing through it, which allows the wiring pattern to have different lead lines 22 for different currents ranging from a slight current to a high current.

Patterned metal plate 21 of wiring board 20 illustrated in FIGS. 2 and 4 includes lead lines 22 having a wide pattern width for high currents and lead lines 22 having a narrow pattern width for slight currents. Lead lines 22 for high currents are used as power lines 22A for passing load currents supplied from battery pack 100 to a load. Lead lines 22 for slight currents are used as detection lines 22B for detecting battery conditions such as the voltages and temperatures of the batteries. Power lines 22A of patterned metal plate 21 illustrated in FIG. 2 connect the batteries in series one another, and detection lines 22B of patterned metal plate 21 are used in lead lines 22 for detecting the voltages of the batteries. Since lead lines 22 of wiring board 20 are connected to external connection terminals 13, connection portions 23 are disposed at the end portions of the lead lines. Each of connection portions 23 is designed to have a size large enough to be reliably connected to external connection terminal 13. Each of power line 22A for high currents has such a wide pattern width that its end portions can be used as they are as connection portions 23 without widening their lateral width. Each of detection lines 22B for detecting slight currents has such a narrow pattern width that the end portions of the detection line preferably include connection portions 23 having a wide lateral width, as illustrated in the figures, with connection portions 23 capable of being reliably connected.

Patterned metal plate 21 is preferably embossed in a step prior to the step of bonding insulating material 26 thereon, thereby forming projections 23A at connection portions 23. Each of projections 23A is processed, as illustrated in FIG. 3, to have a shape that protrudes toward connection terminal 13 to be connected thereto. Projection 23A has a flat surface, resulting in more reliable connection of the projection to connection terminal 13. Projection 23A has a shape protruding into exposure opening 27 of insulating layer 25 and has a size large enough to connect its protruding surface to connection terminal 13. By embossing, projections 23A may be efficiently produced accurately. In connection portions 23 including projections 23A, projections 23A protrude through exposure openings 27 of insulating layer 25 to closely contact the connection surfaces of connection terminals 13, resulting in reliable connection.

Patterned metal plate 21 is formed by punching a single metal plate such that the whole of the plate levels in the same plane, thereby disposing all connection portions 23 in the same plane. Wiring board 20 made of patterned metal plate 21 has advantages that connection portions 23 can be simply and efficiently connected to battery blocks that include, in the same plane, connection terminals to be connected to respective connection portions 23.

### Laminating Step

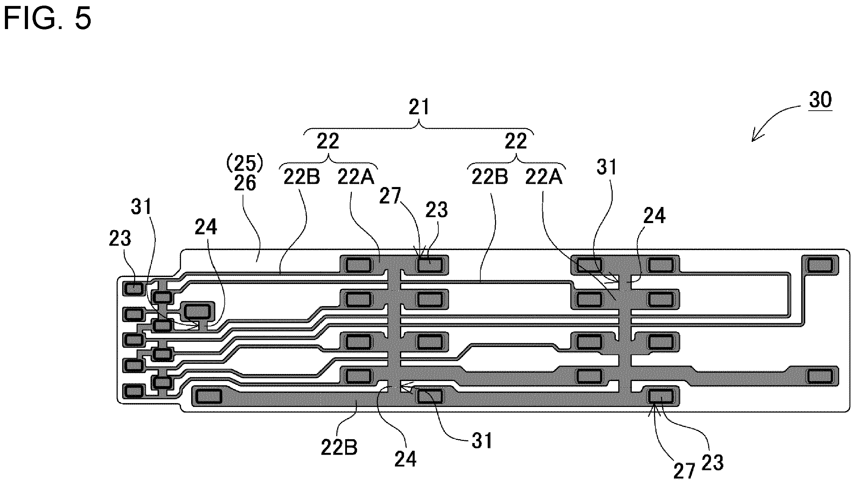

In this step, as illustrated in FIG. 5, insulating material 26 is bonded on a surface of patterned metal plate 21, preferably on each of both surfaces of the plate, to produce intermediate board 30 including insulating layer 25 formed on the surface(s) of patterned metal plate 21. Insulating layer 25 disposes all lead lines 22 in place and insulates the surfaces of lead lines 22 from one another constituting the wiring pattern. Insulating material 26 forming insulating layer 25 may be made of a plastic insulating sheet. Insulating material 26 to be bonded on patterned metal plate 21 may previously have exposure openings 27 through which connection portions 23 are to be exposed. Exposure openings 27 in insulating layer 25 may be formed by locally removing, by cutting, insulating layer 25 from the surfaces of connection portions 23 after insulating layer 25 has been bonded on patterned metal plate 21. The insulating sheet is bonded on each of both surfaces of patterned metal plate 21 with a bonding agent or an adhesion agent to form insulating layer 25. Insulating layer 25 may be formed on the surfaces of patterned metal plate 21 by heat welding an insulating sheet, a thermoplastic plastic sheet, on patterned metal plate 21.

### Modifying Step

In this step, separation holes 28 are locally formed in intermediate board 30, thereby removing coupling portions 24 that couple adjacent lead lines 22. Separation holes 28 separate adjacent lead lines 22, which have been coupled to each other with coupling portions 24, from each other while lead lines 22 remaining disposed in place. Coupling portions 24 are located between adjacent lead lines 22. Therefore, separation holes 28 locally pass though removal regions 31 including coupling portions 24 between lead lines 22, thereby separate adjacent lead lines 22 from each other. Separation holes 28 pass through both insulating layer 25 and patterned metal plate 21 such that coupling portions 24 are removed without cutting out lead lines 22. In wiring board 20 illustrated in the plan view of FIG. 2, plural separation holes 28 are formed to pass through the wiring board between lead lines 22 without cutting out lead lines 22. The separation holes are located on cut-out lines 32 that each laterally extend and are interspaced in the longitudinal direction of a rectangular shape of the wiring board. This causes allows separation holes 28 to separate lead lines 22, from each other, that are multiple rows arranged in order in the lateral direction. Although the removal of coupling portions 24 causes the multiple rows of lead lines 22 to be separated from each other, lead lines 22 remain coupled to each other via insulating layer 25 while lead lines 22 are insulated from one another in the regions without coupling portions 24.

Since wiring board 20 manufactured by the steps described above includes lead lines 22 made of the metal plate to which no restriction is imposed on the thickness and material of the metal plate, the wiring board can adopt the wiring pattern allowing currents to flow through it ranging from an extremely high current exceeding several hundred A (ampere) to a slight current. Moreover, wiring board 20 manufactured by this method does not require the following step as used in manufacturing conventional printed circuit boards. That is, the step is plating the surface of a glass epoxy substrate or the like with copper to form a copper foil thereon, followed by etching while the wiring pattern is masked. Instead of the step, the wiring pattern of wiring board 20 may be formed by punching a metal ion, resulting in efficient mass-production and a wide variety of applications. Hereinafter, an exemplary embodiment in which wiring board 20 is used in a battery pack will be detailed as an example of use of wiring board 20; however, the application of wiring board 20 is by no means limited to the battery pack.

### Battery Pack 100

In battery pack 100 illustrated in FIGS. 6 to 13, assembled battery 9 in which wiring board 20 is connected to battery block 10 is accommodated in case 4. In battery block 10, plural connection terminals 13 are disposed on terminal surface 10A and wiring board 20 is disposed on terminal surface 10A, thereby connecting wiring board 20 to battery block 10.

### Assembled Battery 9

Assembled battery 9 includes battery block 10 including battery cells 1 connected in parallel and in series to one another, wiring board 20 connected to battery block 10, and printed-wiring board 12 connected to wiring board 20 via FPC 14 (a flexible board).

### Battery Block 10)

The present disclosure is not intended to limit battery block 10 connected to wiring board 20 to be specifically to those described below. Battery block 10 including three battery units 11 will be detailed below as one of exemplary embodiments; however, the description is not intended to cause battery block 10, which is connected to wiring board 20, to be specifically limited to the following: In battery block 10 according to the embodiment, each of battery units 11 includes ten battery cells 1. Each of battery cells 1 is a cylindrical cell; however, battery cell 1 may be all of other types of secondary batteries including a rectangular cell and a polymer secondary battery. In battery block 10, three battery cells 1 are connected in parallel to one another to constitute a parallel unit and ten parallel units are connected in series to one another.

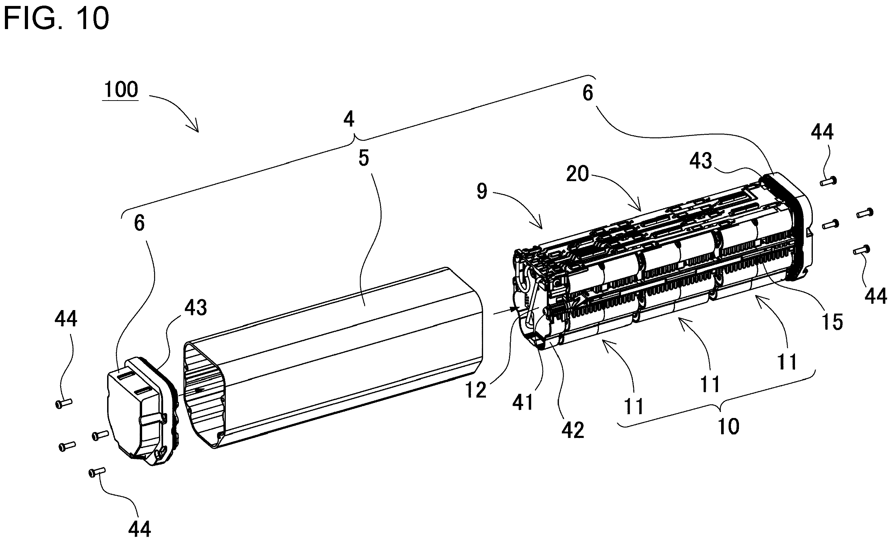

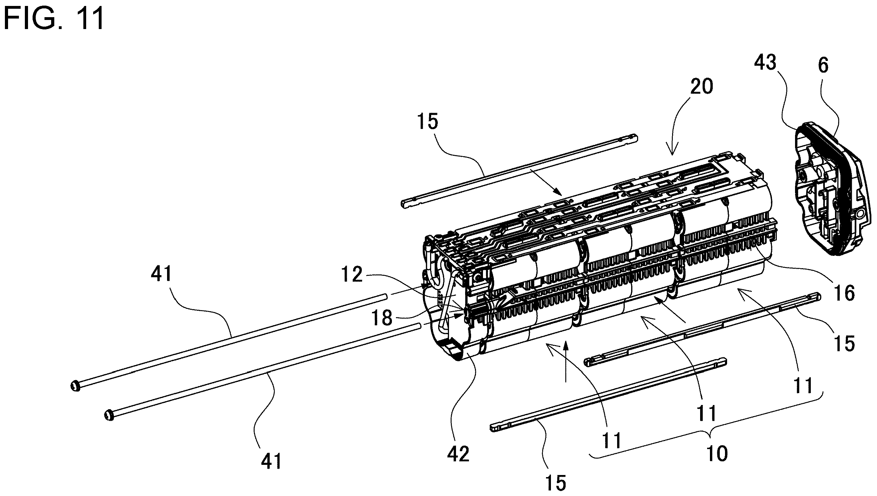

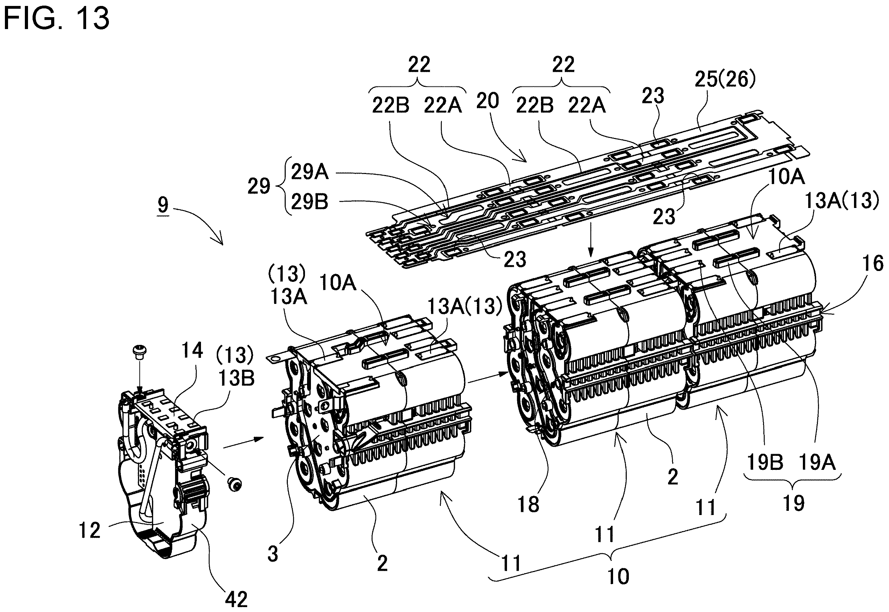

Battery block 10 is coupled to wiring board 20 described above to constitute assembled battery 9. Assembled battery 9 illustrated in the figures further includes printed-wiring board 12 in addition to wiring board 20. Printed-wiring board 12 is connected to wiring board 20 via FPC 14. Battery block 10 has a block shape having an overall length larger than the lateral width and vertical width of the block in FIGS. 10 and 11, and includes printed-wiring board 12 disposed on an end surface of battery block 10. Battery block 10 has a rectangular columnar block shape and its outer peripheral surface includes one surface (the upper surface in the figure) functioning as terminal surface 10A. Connection terminals 13 flush with one another are disposed on terminal surface 10A, as illustrated in FIG. 13. Multiple rows of connection portions 23 flush with one another are disposed on terminal surface 10A, thereby allowing connection portions 23 of wiring board 20 to be connected to connection terminals 13 of battery block 10. In assembled battery 9, battery block 10 includes both printed-wiring board 12 disposed on an end portion of the battery block and wiring board 20 disposed on one side surface of the battery block, and printed-wiring board 12 and wiring board 20 are arranged perpendicularly to each other, with printed-wiring board 12 being connected to wiring board 20 with FPC 14 bendable. Assembled battery 9 illustrated in FIG. 13 is assembled such that one end of FPC 14 includes connection terminals 13B and that connection portions 23 of wiring board 20 are placed on connection terminals 13B, followed by laser welding between connection terminals 13B and connection portions 23. The other end of FPC 14 may be connected to printed-wiring board 12 via a connector or, alternatively, may be connected to printed-wiring board 12 by soldering.

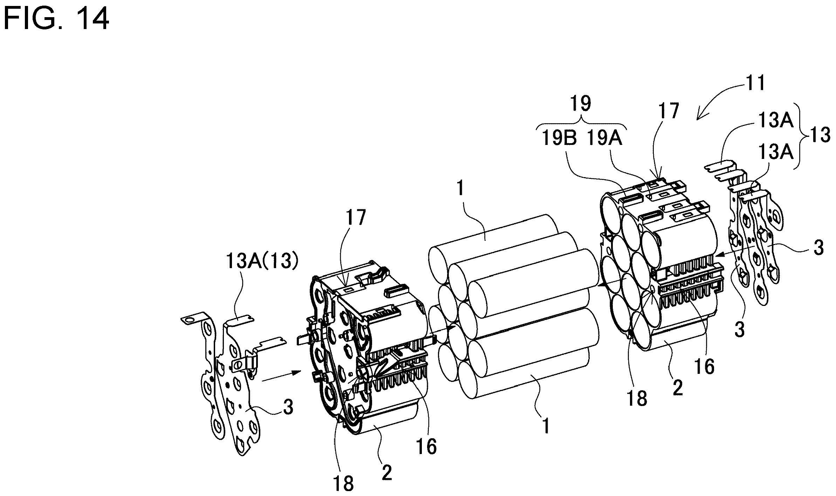

Battery block 10 illustrated in FIGS. 10 to 13 has the block shape in which plural battery units 11 are linearly disposed. In battery unit 11 illustrated in FIG. 14, battery cells 1, cylindrical cells, are disposed parallel to one another. In battery unit 11, battery cells 1, the cylindrical cells, are disposed at fixed positions with cell holder 2. The cylindrical cells each have positive and negative electrodes disposed on the both ends of the cell that are exposed from cell holder 2. The electrodes of the cylindrical cells are welded to lead plates 3. Each of lead plates 3 connects adjacent cylindrical cells to each other in parallel or in series to each other. Lead plate 3 connected to the electrodes of battery cells 1 has an end portion disposed on terminal surface 10A of battery block 10. The end portion functions as connection terminal 13. Connection terminal 13 of lead plate 3 disposed on terminal surface 10A is connected to connection portion 23 of wiring board 20. Wiring board 20 connected to connection terminals 13 on terminal surface 10A connects battery cells 1 of battery units 11 in series to one another via lead lines 22. Lead lines 22 connecting battery cells 1 in series to one another are power lines 22A that have a wide pattern width for passing load currents. Battery cells 1 of battery units 11 may be connected in parallel or in series to one another with lead plates 3 and further connected in series or in parallel to one another via power lines 22A of wiring board 20.

### Cell Holder 2

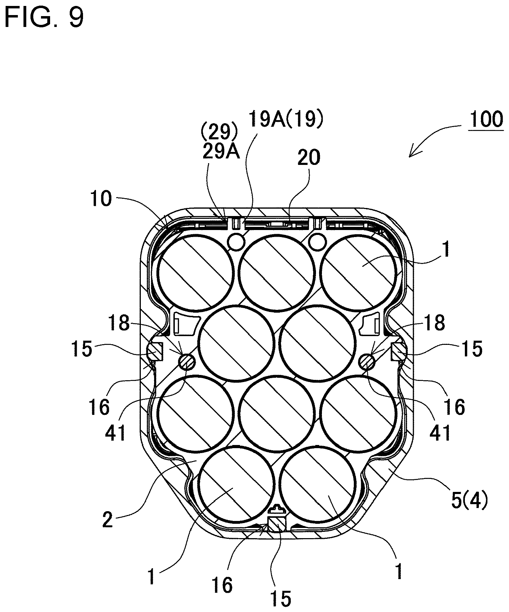

In battery unit 11, as illustrated in FIG. 14, each of the cylindrical cells is disposed at its fixed position with cell holder 2 including of plastic-molded bodies formed by molding, with the molded bodies being as bisected bodies of the cell holder. The inner surfaces of cell holder 2 have a shape that allows the cylindrical cells to be fitted in the cell holder, thereby disposing the cylindrical cells at their respective fixed positions. In the bottom surface and side surfaces on both sides of cell holder 2, fitting grooves 16 are disposed to guide elongated cushioning materials. Fitting grooves 16 guide cushioning materials 15, rubber-like elastic bodies, as illustrated in FIGS. 9 and 11. Cushioning materials 15 contact the inner surface of the case, thereby absorbing the impact of battery block 10 when hitting the inner surface of the case.

Cell holder 2 further has terminal recesses 17 in terminal surface 10A thereof which allow connection terminals 13 to be disposed at their fixed positions while the connection terminals 13 are formed at the tips of lead plates 3. Terminal recesses 17 cause connection terminals 13 to be disposed at their fixed positions, thereby avoiding misalignment of connection terminals 13 with respect to connection portions 23 of wiring board 20. Cell holder 2 further includes positioning projections 19 that allow wiring board 20 to be disposed at a fixed position on terminal surface 10A. Positioning projections 19 are guided into positioning holes 29 of wiring board 20, thereby allowing wiring board 20 to be disposed at the fixed position on terminal surface 10A. Cell holder 2 include projections 19A with ridge shapes to be inserted into slit-shaped positioning holes 29A provided in wiring board 20 and projection-positioning projections 19B to be inserted into dot-shaped positioning holes 29B disposed in wiring board 20. Slit-shaped positioning holes 29A are each disposed between lead lines 22 that are adjacent to each other and disposed in wiring board 20. Dot-shaped positioning holes 29B are disposed in the vicinities of connection portions 23 of wiring board 20. Ridge-shaped positioning projections 19A are inserted into slit-shaped positioning holes 29A while projection-positioning projections 19B are inserted into dot-shaped positioning holes 29B, thereby allowing wiring board 20 to be disposed at the fixed position. Since projection-positioning projections 19B are disposed in the vicinities of connection terminals 13, i.e., disposed adjacent to connection portions 23, which reliably avoids relative misalignment between connection portions 23 and connection terminals 13, resulting in the reliable connections between them, in particular, reliable laser welding of them.

Cell holder 2 has coupling holes 18 into which coupling bolts 18 are to be inserted, respectively, in both side portions of cell holder 2 so as to couple adjacent battery units 11 linearly to each other. Coupling bolts 41 are inserted into coupling holes 18 to couple adjacent battery units 11 linearly to each other, thereby constituting battery block 10. Coupling bolts 41 are screwed into one of case lids 6 of case 4 to be described later so as to couple all battery units 11 linearly to one another, thereby securing battery units 11 to case lid 6.

### Wiring Board 20

In wiring board 20 illustrated in FIGS. 1 and 2, insulating layer 25 is disposed on the surface of wiring board 20 by bonding insulating material 26 on patterned metal plate 21. Patterned metal plate 21 of wiring board 20 has a wiring pattern that includes lead lines 22 for high currents and lead lines 22 for slight currents. Further, in patterned metal plate 21, lead lines 22 for high currents have a larger pattern width and lead lines 22 for slight currents have a smaller pattern width, thereby allowing each of lead lines 22 to exhibit respective optimal flowing currents. Lead lines 22 for high currents connect battery units 11 to one another to serve as power lines 22A for passing load currents of battery pack 100. Lead lines 22 for slight currents serve as detection lines 22B for detecting battery conditions, such as voltages, of battery cells 1. Power lines 22A have a pattern width of, e.g., about 5 mm for passing currents ranging from 20 to 50 A. Detection lines 22B have a pattern width of 1 mm or less.

In wiring board 20, lead lines 22 include connection portions 23 at the end portions of the lead lines. The connected portions are to be connected to battery block 10 and FPC 14. Since power lines 22A have the larger pattern width, their end portions function as connection portions 23. Since detection lines 22B have the smaller pattern width, their end portions include connection portions 23 having a locally large lateral width. Connection portions 23 are connected to connection terminals 13 of battery block 10 and FPC 14 by welding or soldering.

Each of connection portions 23 includes projection 23A that protrudes through exposure opening 27 formed in insulating layer 25, as illustrated in FIG. 3. Projection 23A may be disposed preferably by embossing patterned metal plate 21 as described above. Projection 23A projects from the surface of insulating layer 25 or, a flat surface of the projection is flush with the surface of insulating layer 25, which allows reliable connection of the projection to the connection terminal. In particular, connection portion 23 with projection 23A is stably and reliably welded to connection terminal 13 by laser welding. This is because the laser welding is carried out with the surface of projection 23A closely contacting connection terminal 13 without clearance.

In battery block 10 and wiring board 20, connection terminals 13 disposed on battery block 10 are flush with one another, and connection portions 23 disposed in wiring board 20 are flush with one another. Connection terminals 13 and connection portions 23 are disposed at respective positions facing to each other, thereby allowing connection between battery block 10 to be welded to wiring board 20 by laser welding efficiently. This is because connection portions 23 are welded to connection terminals 13 as follows: Wiring board 20 is disposed on terminal surface 10A of battery block 10. Each of connection portions 23 is irradiated with a laser beam while connection portions 23 closely contacting connection terminals 13 by pressing. Further, wiring board 20 including connection portions 23 including projections 23A has advantages that the laser welding is carried out reliably by causing projections 23A to protrude through exposure openings 27 of insulating layer 25 so that the surfaces of projections 23A are stably and reliably in close contact with connection terminals 13.

In battery pack 100 described above, connection terminals 13 and connection portions 23 are flush with one another. In wiring board 20, connection portions 23 may not necessarily be flush with one another. This is because the connection portions may be welded to the connection terminals of external connection portions by bending the wiring board to a shape that allows the connection portions to closely contact the connection terminals which are not flush with one another. Connection portions 23 and connection terminals 13 may be connected by laser welding reliably and efficiently; however, they may also be connected by resistance welding or soldering.

Each of projection 23A of connection portion 23 may have a facing plane of a planar shape, resulting in more reliable connection to connection terminal 13. Projection 23A has the shape protruding through exposure opening 27 of insulating layer 25, and the protruding surface of the projection has a size large enough to be connected to connection terminal 13. Embossing may efficiently provide projections 23 with high processing accuracy. Connection portions 23 having projections 23A may cause projections 23A to protrude through exposure openings 27 of insulating layer 25, which allowing projections 23A to closely contact the connection surfaces of connection terminals 13, resulting in the reliable connection.

### Printed-Wiring Board 12

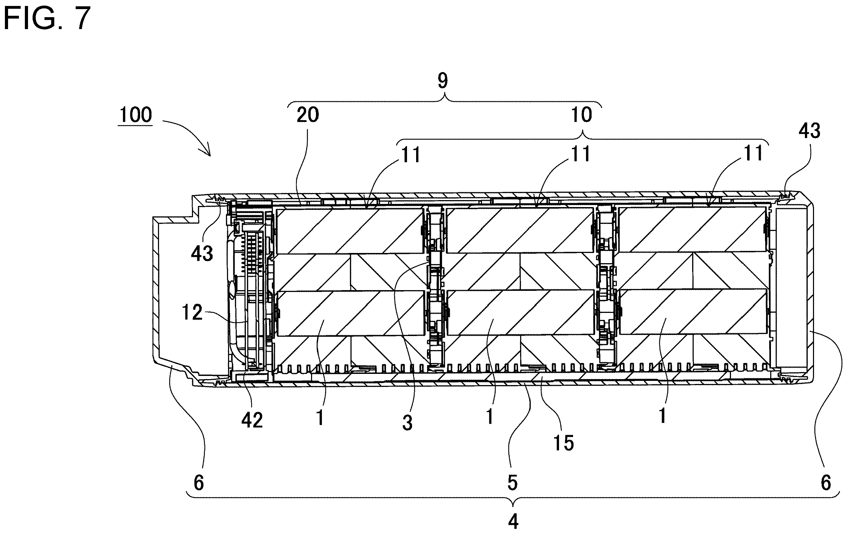

Assembled battery 9 illustrated in FIGS. 7, 8, 10, and 11 includes printed-wiring board 12 disposed at the end portion of battery block 10. Printed-wiring board 12 may be disposed at a fixed position of battery block 10 via board holder 42. In the assembled battery illustrated in the figures, both board holder 42 allowing printed-wiring board 12 to be disposed at the fixed position and coupling bolts 41 passing through cell holder 2 are secured to case lid 6, which causes printed-wiring board 12 to be disposed at the fixed position of battery block 10 with coupling bolts 41. A voltage-detecting circuit to detect voltages of battery cells 1 is mounted onto printed-wiring board 12. The voltage-detecting circuit detects the voltage of each of battery cells 1, thereby reducing imbalance among the remaining capacities of the battery cells. The voltage-detecting circuit of printed-wiring board 12 is connected to the electrodes of each battery cell 1 via FPC 14 and detection lines 22B of wiring board 20, thereby detecting the voltage of each battery cell 1. Detection lines 22B are coupled to connection portions 23 connected to the electrodes of battery cells 1, and input the voltage of each battery cell 1 into the voltage-detecting circuit via FPC 14.

### Case 4

Case 4 includes case tube 5 having both ends opened and case lids 6 closing the both ends of case tube 5. Case tube 5 is a metal tube made of, e.g., aluminum, formed by drawing into a shape having a uniform cross-sectional shape. Case tube 5 is coupled to case lids 6 in a watertight or hermetic state by passing set screws 44 through the outer peripheral portions of case lids 6 and screwing them into case tube 5 while seals 43 are each disposed between the end surface of case tube 5 and the inner surface of case lid 6. In this battery pack, printed-wiring board 12 is disposed inside case lids 6 and wiring board 20 is disposed on the outer peripheral surface of battery block 10. Battery pack 100 has a unique structure in which printed-wiring board 12 is disposed on the end surface of battery block 10. Wiring board 20 is disposed on the side surface of battery block 10. Printed-wiring board 12 and wiring board 20 are coupled to each other with FPC 14 deformable. Then this structure allows wiring board 20 and printed-wiring board 12 to be accommodated in case 4 efficiently.

### INDUSTRIAL APPLICABILITY

A wiring board according to the present disclosure is applicable particularly to applications that use lead wires or lead plates for high currents and slight currents.

### REFERENCE MARKS IN THE DRAWINGS

- 100: battery pack
- 1: battery cell
- 2: cell holder
- 3: lead plate
- 4: case
- 5: case tube
- 6: case lid
- 9: assembled battery
- 10: battery block
- 10A: terminal surface
- 11: battery unit
- 12: printed-wiring board
- 13, 13A, 13B: connection terminal
- 14: FPC
- 15: cushioning material
- 16: fitting groove
- 17: terminal recess
- 18: coupling hole
- 19: positioning projection
- 19A: protruding-ridge-shaped positioning projection
- 19B: projection-positioning projection
- 20: wiring board
- 21: patterned metal plate
- 22: lead line
- 22A: power line
- 22B: detection line
- 23: connection portion
- 23A: projection
- 24: coupling portion
- 25: insulating layer
- 26: insulating material
- 27: exposure opening
- 28: separation hole
- 29: positioning hole
- 29A: slit-shaped positioning hole
- 29B: dot-shaped positioning hole
- 30: intermediate board
- 31: removal region
- 32: cut-out line
- 41: coupling bolt
- 42: board holder
- 43: seal
- 44: set screw

## Claims

1. A wiring board comprising:
a patterned metal plate made of a metal plate cut in a wiring pattern, the patterned metal plate including a plurality of lead lines including a connection portion; and
an insulating layer disposed on a surface of the patterned metal plate, wherein
the insulating layer has an exposure opening therein allowing the connection portion to be exposed through the exposure opening.

2. The wiring board of claim 1, wherein the patterned metal plate is made of the metal plate punched or cot in the wiring pattern.

3. The wiring board of claim 1 or 2, wherein the patterned metal plate has a thickness of 0.1 mm or more.

4. The wiring board of any one of claims 1 to 3, wherein
the wiring board has a separation hole therein passing through both the patterned metal plate and the insulating layer, the separation hole being provided between adjacent lead lines out of the plurality of lead lines, and
the separation hole separates the adjacent lead lines from each other.

5. The wiring board of any one of claims 1 to 4, wherein the connection portion includes a projection protruding through the exposure opening.

6. The wiring board of claim 5, wherein the projection has a surface either being flush with a surface of the insulating layer or protruding from the insulating layer.

7. A method of manufacturing a wiring board, comprising:
a cutting step of providing a patterned metal plate by cutting a metal plate in a wiring pattern, the patterned metal plate including a coupling portion and a plurality of lead lines including a connection portion, adjacent lead lines of the plurality of lead lines being coupled to each other with the coupling portion;
a laminating step of providing an intermediate board including the patterned metal plate and an insulating layer on a surface of the patterned metal plate by bonding an insulating material on the surface of the patterned metal plate; and
a modifying step of separating the plurality of lead lines from each other by locally removing a portion of the intermediate board in a removal region including the coupling portion.

8. The method of claim 7, wherein, in the laminating step, the insulating material is bonded on the surface of the patterned metal plate, the insulating material having an exposure opening allowing the connection portion to be exposed through the exposure opening.

9. The method of claim 8, further comprising
a step of embossing the connection portion to cause the connection portion to protrude through the exposure opening.

10. The method of claim 7 or 8, wherein the plurality of lead lines include a plurality of connection portions including the connection portion, the plurality of connection portions being flush with one another.

11. A battery pack comprising:
a battery block including a plurality of battery cells and a plurality of connection terminals, the battery block having a terminal surface on which the plurality of connection terminals are provided;
a wiring board including a plurality of connection portions connected to the plurality of connection terminals of the battery block, respectively; and
a case accommodating an assembled battery therein, the assembled battery including the battery block and the wiring board coupled to the battery block, wherein
the wiring board includes:
a patterned metal plate made of a metal plate cut in a wiring pattern, the patterned metal plate including a plurality of lead lines coupled to the plurality of connection portions; and
an insulating layer bonded onto a surface of the patterned metal plate such that adjacent lead lines out of the plurality of lead lines are disposed at fixed positions and insulated from each other.

12. The battery pack of claim 11, wherein the wiring pattern of the wiring board includes:
a power line connected to a load current line of the battery block; and
a detection line configured to detect conditions of the plurality of battery cells.

13. The battery pack of claim 11 or 12, wherein the assembled battery further includes a printed-wiring board connected to the wiring board.

14. The battery pack of claim 13, wherein the printed-wiring board includes a current-detecting circuit for the plurality of battery cells.

15. The battery pack of claim 13 or 14, wherein the printed-wiring board is connected to the wiring board with a flexible board (FPC).

16. The battery pack of any one of claims 13 to 15, wherein
the battery block has a block shape having an overall length, a lateral width, and a vertical width, the overall length being larger than the lateral width and the vertical width, and
the printed-wiring board is disposed on an end surface of the battery block.

17. The battery pack according to any one of claims 11 to 16, wherein
the plurality of connection terminals are flush with one another and provided on the terminal surface, the terminal surface being one of outer circumferential surfaces of the battery block, and
the plurality of connection portions of the wiring board are flush with one another and disposed on the terminal surface.

18. The battery pack of any one of claims 11 to 17, wherein the plurality of connection portions of the wiring board are welded to the connection terminals of the battery block.

19. The battery pack according to any one of claims 11 to 18, wherein
the insulating layer has exposure openings therein through which the plurality of connection portions are exposed, and
the plurality of connection portions of the wiring board include projections positioned in the exposure openings, the projections being welded to the connection terminals by laser welding.

20. The battery pack of any one of claims 13 to 16, wherein
the case includes:
a case tube having both ends opened, and
case lids closing the both ends of the case tube,
the printed-wiring board is disposed on an inner side of the case lids, and
the assembled battery is disposed inside the case tube such that the wiring board is disposed on an outer circumferential surface of the battery block.

21. The battery pack of to claim 20, wherein
the battery block includes:
a plurality of battery units linearly disposed; and
a coupling bolt linearly coupling the plurality of battery units to one another,
each of the plurality of battery units includes a battery holder disposing the plurality of battery cells at fixed positions, and
the coupling bolt passes through the battery holder such that end portions of the coupling bolt are coupled to the case lids to linearly couple the plurality of battery units to one another.

22. The battery pack of claim 21, wherein
the each of the plurality of battery units further includes a board holder dispose the printed-wiring board in a fixed position,
the coupling bolt passes through both the board holder and the battery holder, the end portion of the coupling bolt being coupled to one of the case lids, and
the plurality of battery blocks, the printed-wiring board, and one of the case lids are coupled unitarily with the coupling bolt.

23. The battery pack of any one of claims 20 to 22, wherein
the case tube is a metal tube having an identical cross-sectional shape, and
the case lids and the case tube are coupled to one another with a set screw through the case lids into one of the case tube.

24. The battery pack of any one of claims 11 to 23,
the battery block includes one or more positioning projections disposing the wiring board at a fixed position,
the wiring board has one or more positioning holes therein guiding the one or more positioning projections, respectively, and
the wiring board is disposed at the fixed position of the battery block by guiding the one or more positioning projections into the one or more positioning holes.

25. The battery pack of claim 24, wherein the one or more positioning holes comprise a plurality of positioning holes adjacent to the plurality of connection portions.

26. The battery pack of claim 24 or 25, wherein
the one or more positioning holes include:
a slit-shaped positioning hole positioned between adjacent lead lines; and
a dot-shaped positioning hole disposed adjacent to the plurality of connection portions, and
the one or more positioning projections include:
a positioning projection guided into the slit-shaped positioning hole; and
a positioning projection guided into the dot-shaped positioning hole.
